# EUROPEAN PATENT SPECIFICATION

(11) **EP 4 105 949 B1**
(45) Date of publication and mention of the grant of the patent: **18.11.2026**
(21) Application number: 22188038.8
(22) Date of filing: 30.08.2019
(51) Int. Cl.: H01B 12/06, H01R 4/68, H10N 60/20

(54) **FLEXIBLE HTS CURRENT LEADS AND METHODS OF MANUFACTURING OF FLEXIBLE HTS CURRENT LEADS**
FLEXIBLE HTS-STROMLEITUNGEN UND VERFAHREN ZU IHRER HERSTELLUNG
CONDUCTEURS SOUPLES EN SUPRACONDUCTEUR À HAUTE TEMPÉRATURE ET PROCÉDÉS DE FABRICATION DE CONDUCTEURS SOUPLES EN SUPRACONDUCTEUR À HAUTE TEMPÉRATURE

(30) Priority: 07.09.2018 GB 201814582
(43) Date of publication of application: 21.12.2022
(62) Document number(s) of the earlier application(s) in accordance with Art. 76 EPC: 19763068.4 / 3 847 676
(73) Proprietor: Tokamak Energy Ltd, Abingdon, Oxfordshire OX14 4SD (GB)
(72) Inventor: van Nugteren, Bas, Abingdon, OX14 5TN (GB); Brittles, Greg, Abingdon, OX14 4SD (GB)
(74) Representative: Marks & Clerk LLP

(56) References cited:
- EP-A1- 2 587 493
- JP-A- 2003 331 660
- US-A1- 2005 173 149
- US-A1- 2008 194 411
- US-A1- 2016 240 286

## Description

### Field of the Invention

The present invention relates to superconductor devices. In particular, the present invention relates to current leads comprising high temperature superconductor.

### Background

Superconducting materials are typically divided into "high temperature superconductors" (HTS) and "low temperature superconductors" (LTS). LTS materials, such as Nb and NbTi, are metals or metal alloys whose superconductivity can be described by BCS theory. All low temperature superconductors have a critical temperature (the temperature above which the material cannot be superconducting even in zero magnetic field) below about 30K. The behaviour of HTS material is not described by BCS theory, and such materials may have critical temperatures above about 30K (though it should be noted that it is the physical differences in superconducting operation and composition, rather than the critical temperature, which define HTS material). The most commonly used HTS are "cuprate superconductors" - ceramics based on cuprates (compounds containing a copper oxide group), such as BSCCO, or ReBCO (where Re is a rare earth element, commonly Y or Gd). Other HTS materials include iron pnictides (e.g. FeAs and FeSe) and magnesium diboride (MgB₂).

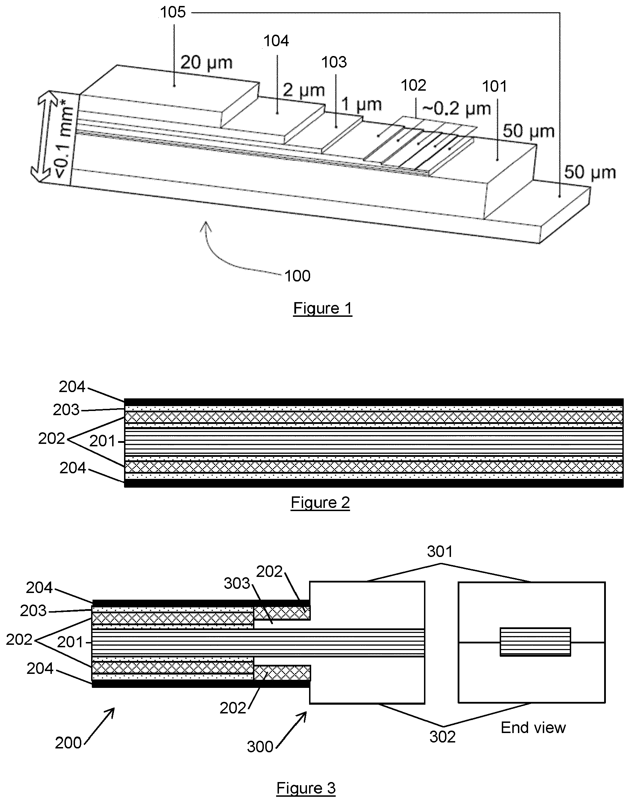

ReBCO is typically manufactured as tapes, with a structure as shown in Figure 1. Such tape 100 is generally approximately 100 µm thick, and includes a substrate 101 (typically electropolished hastelloy approximately 50 µm thick), on which is deposited by IBAD, magnetron sputtering, or another suitable technique a series of buffer layers known as the buffer stack 102,of approximate thickness 0.2 µm. An epitaxial ReBCO-HTS layer 103 (deposited by MOCVD or another suitable technique) overlays 15 the buffer stack, and is typically 1 µm thick. A 1-2 µm silver layer 104 is deposited on the HTS layer by sputtering or another suitable technique, and a copper stabilizer layer 105 is deposited on the tape by electroplating or another suitable technique, which often completely encapsulates the tape.

The substrate 101 provides a mechanical backbone that can be fed through the manufacturing line and permit growth of subsequent layers . The buffer stack 102 is required to provide a biaxially textured crystalline template upon which to grow the HTS layer, and prevents chemical diffusion of elements from the substrate to the HTS which damage its superconducting properties. The silver layer 104 is required to provide a low resistance interface from the ReBCO to the stabiliser layer, and the stabiliser layer 105 provides an alternative current path in the event that any part of the ReBCO ceases superconducting (enters the "normal" state).

A common issue in the design of superconducting systems such as magnets is to obtain high currents at cryogenic temperatures with minimal heat load to the cryogenic environment. Usually, a high current is generated at room temperature (i.e. outside of the cryogenic environment), and transported into the cryostat by current leads. The current leads are typically a mix of copper (for temperatures around 300K), brass (for temperatures between 300K and 77K), and high temperature superconductors (HTS) (for temperatures below 77K). Current leads may also be used to transport current in regions of the system at a single temperature.

Other solutions may be used, e.g. having a switched mode power supply which transfers power into the cryostat, but these will generally still involve HTS current leads between the power supply and the superconducting system.

HTS current leads may be either rigid or flexible. Rigid leads may cause mechanical issues due to thermal shrinkage when the cryostat is cooled. Flexible leads must be handled carefully, as HTS tape will develop cracks if it is bent with too small a radius, and will have reduced critical current if it is under strain due to bending while operational.

JP2003331660A discloses a metal sheathed superconducting wire, having a plurality of superconducting cores covered with a metal sheath, a heat resistant metal wound around the cores, and an insulating covering material covering the heat resistant metal. US2008/194411A1 discloses a HTS wire comprising a HTS layer thermally coupled to a stabiliser/encapsulant.

US2005/173149A1 discloses a superconducting cable with a flexible core. US2016/240286A1 discloses a HTS cable subassembly comprising a stack of HTS tapes wrapped with a wrapper material.

EP2587493A1 discloses a HTS coil comprising a HTS wire covered by polyimide and impregnated with epoxy resin.

### Summary

Aspects of the present invention provide a high temperature superconducting, HTS, current lead, a method of manufacturing an HTS current lead and a method of reshaping an HTS current lead, as set out in the appended set of claims.

### Brief Description of the Drawings

Figure 1 is a schematic diagram of an HTS tape;
Figure 2 is a schematic diagram of an exemplary construction of an HTS current lead;
Figure 3 is a schematic diagram of an exemplary construction of an HTS current lead comprising terminals.

### Detailed Description

A construction for an HTS current lead is shown in Figure 2. The HTS current lead comprises a plurality of HTS tapes 201, which are held within a braided sleeve 202. The tapes 201 and braided sleeve 202 are encased in wax 203, which is held in place by a sheath 204.

The HTS tapes may be stacked (i.e. all parallel) or arranged into a cable in some other orientation (e.g. twisted stacks or braided cables).

The braided sleeve acts to make the current lead bulkier, which means that it is much more difficult to bend the current lead with a bending radius which would cause damage to the tapes, as compared to bending the cable alone. The braided sleeve may comprise metal in order to also act as an electrical "stabiliser" for the HTS tapes, i.e. as an alternative current path in the event that the current through the HTS tapes exceeds the critical current. Suitable metals for the braided sleeve include brass or copper, and the metal filaments may be coated with another metal such as PbSn solder.

The braided sleeve may be configured to entirely prevent bending below a certain radius of curvature.

The wax acts to keep the current lead structurally stable during handling of the system and during operation of the superconducting system. The current lead is heated up to melt the wax, so that it is bent into a desired shape, and then allowed to cool to retain that shape. Suitable waxes will have a melting point above an intended operating temperature of the current lead (e.g. 77K, or the critical temperature of the HTS tapes), or above room temperature (290K, to ensure they are stable at room temperature), but below a degradation temperature of the HTS (i.e. a temperature at which permanent damage to the HTS would occur, usually around 200°C). If the melting point of the braided sleeve, sheath, or any solder in the HTS current lead is below the HTS degradation temperature, then the melting point of the wax may be below this as well - or heat may be applied in such a way as to prevent the lower melting point components from reaching the same temperature as the wax (e.g. avoiding soldered areas).

While wax is used herein as an example, other substances with a melting point above room temperature and below the HTS degradation temperature would also be suitable for use as stabiliser materials to impregnate the HTS current lead.

The properties of the wax during cryogenic cooling may also be considered - some waxes will break down into powder if cooled to cryogenic temperatures and warmed back to room temperature, and would not be suitable for applications where cycles of cooling and warming are expected (but would be suitable for devices kept at cryogenic temperatures permanently). Which waxes perform well at cryogenic temperatures can be determined by routine experimentation.

The rigidity of the wax at room temperature and at cryogenic temperatures will also be a consideration, depending on the design constraints of the system. More rigid waxes will offer better structural protection during operation (e.g. against Lorentz forces), but may suffer from mechanical issues due to thermal shrinkage. More flexible waxes will offer less protection from Lorentz forces, but will be able to flex more easily to account for thermal shrinkage.

One wax which satisfies the above conditions is beeswax (melting temperature of 60°C, and stable through cryogenic cycles). Where "wax" is used herein, this may also be a mixture of different waxes or other materials to achieve the desired properties.

The sheath 204 may be a heat-shrink material, such that when the wax is heated in order to reshape the cable, the heat shrink material will shrink to encourage the wax to fill any voids in the structure. Once the HTS current lead has been shaped into position and the wax has solidified, the sheath 204 may be removed if desired, or kept on for additional electrical insulation.

Many materials which would be otherwise suitable to provide a leak-tight sheath will become brittle at cryogenic temperatures. Therefore, the sheath 204 may comprise a first "room temperature" sheath, which is leak-tight at room temperature and at the temperature required to melt the wax, and a second "cryogenic" sheath surrounding the "room temperature" sheath, which maintains structural integrity at cryogenic temperatures.

Figure 3 is a schematic illustration of the connection between an HTS current lead according to figure 2, and a terminal block. The terminal block may be used to connect the HTS current lead electrically, thermally, and structurally to other components.

The HTS current lead 200 has the same components as previously - i.e. the HTS tapes 201, braided sleeve 202, wax 203, and sheath 204. The HTS tapes 201 extend beyond the braided sleeve 202 and into the terminal block 300. Additional copper tapes may be placed between the HTS tapes such that they are spaced out further within the terminal block, and provided with additional copper in case of excess current - the terminal block is likely to undergo resistive heating, which will lower the critical current of the tapes and result in a greater risk of quenching, and the excess copper helps mitigate this.

The terminal block may be formed from upper 301 and lower 302 portions, which the HTS tapes are clamped between. Alternatively, the terminal block may be formed as a single unit having a recess or through hole to receive the HTS tapes. Other suitable constructions may also be used. The recess or through hole in the terminal block (or the space between the two portions in the clamped example) may fit the HTS tapes to within 0.1mm to allow them to be easily soldered to the terminal block.

The braided sleeve 202 surrounds a protrusion 303 on the side of the terminal block, and the sheath 204 also extends around this protrusion. The braided sleeve 202, HTS tapes 201, and terminal block 300 may be connected by soldering, e.g. by dipping the entire block and the protrusions in solder (keeping the sheath 204 and wax 203 away from the hot solder). The solder should be chosen to have a melting point below the degradation temperature of the HTS. Sealant may be applied to be join between the terminal block and the sheath 204.

The HTS current lead, including terminal blocks may be manufactured by the following steps:
1. HTS tapes are cut to length, and assembled into a cable (e.g. by stacking).
2. A first terminal block is placed over one end of the cable.
3. The braided sleeve is cut to the desired length and slid over the cable, up to the first terminal block and around the protrusion.
4. The first terminal block is dipped in solder to fix the HTS cable and braided sleeve to each other and to the first terminal block.
5. The sheath is slid over the braided sleeve, and sealed at the end adjacent to the first terminal block.
6. The sheath is filled with wax, and temporarily fixed at the end furthest from the first terminal block, such that that end is held some way away from where the second terminal block will be attached.
7. The second terminal block is placed over the free cable end, and the braided sleeve is slid over the protrusion of second terminal block.
8. The second terminal block is dipped in solder to fix the HTS cable and braided sleeve to each other and the second terminal block.
9. The sheath is slid down to second terminal block, and sealed at that end.
10. The assembly is heated to melt the wax (and shrink the heat-shrink material, if that is used for the sheath).

These steps may be varied appropriately for terminals other than the terminal blocks described with reference to Figure 3. In general, forming the HTS current lead will require the steps of:
1. Providing an HTS cable comprising a plurality of tapes.
2. Placing a braided sleeve around the cable.
3. Placing a sheath around the braided sleeve.
4. Filling the sheath with wax (either molten or in the form of pellets).
5. Sealing the sheath.
6. Melting the wax if pellets were used.

These steps may be re-ordered or broken up into sub-steps as required to connect the HTS cable to the terminals used.

Where HTS cables comprising stacked tapes are used (and potentially for other cable designs), the relative orientations of the terminal blocks will be limited to close to their orientation when the cable is made (e.g. if the terminal blocks are parallel, then they will remain close to parallel as the HTS current lead is bent). This is because significantly changing the relative orientations of the terminal blocks would require HTS tapes on one side of the stack to extend relative to HTS tapes on the other side of the stack. This can be mitigated by pre-bending the stacked HTS cable prior to affixing the second terminal block, so that the terminal blocks are in the desired relative orientation.

## Claims

1. A high temperature superconducting, HTS, current lead (200) comprising:
an HTS cable comprising a plurality of HTS tapes (201);
a braided sleeve (202) around the HTS cable;
a stabiliser material (203) being impregnated in the HTS cable and the braided sleeve (202),
wherein the stabiliser material (203) has a melting point above 290K and below a thermal degradation temperature of the HTS tapes (201) such that the HTS current lead is configured to be bent and to be reshaped into a desired shape, when heated to a temperature that melts the stabiliser material (203), and to retain said desired shape when cooled.

2. An HTS current lead (200) according to claim 1, wherein the stabiliser material is a wax (203).

3. An HTS current lead (200) according to any preceding claim, wherein the braided sleeve (202) comprises a metal, and is electrically connected to the HTS cable, optionally, wherein the metal is copper or brass.

4. An HTS current lead (200) according to any preceding claim, and comprising a respective terminal block (300) at each end of the HTS cable, each terminal block (300) being electrically connected to the HTS tape, and being configured for electrical connection to external components.

5. An HTS current lead (200) according to claim 4, wherein each terminal block (300) is soldered to the HTS cable.

6. An HTS current lead (200) according to claim 4 or 5, wherein each terminal block (300) is affixed or soldered to the braided sleeve (202).

7. An HTS current lead (200) according to claim 6, wherein each terminal block (300) comprises a protrusion (303) extending around a portion of the HTS cable, and the braided sleeve (202) extends around the protrusion (303).

8. An HTS current lead (200) according to any preceding claim, and comprising a leak-tight sheath (204) surrounding the stabiliser material, optionally formed from a heat shrink material, and optionally:
wherein the leak-tight sheath (204) is configured to be removed, or,
wherein the leak-tight sheath (204) comprises an inner sheath formed from a leak-tight material, and an outer sheath formed from a material which is configured to maintain structural integrity after cooling to below 77K.

9. An HTS current lead (200) according to any preceding claim, wherein the braided sleeve is configured to entirely prevent bending of the HTS cable below a certain radius of curvature.

10. A method of manufacturing a HTS current lead (200), the method comprising:
providing an HTS cable comprising a plurality of HTS tapes (201);
placing a braided sleeve (202) around the cable;
placing a sheath (204) around the braided sleeve (202);
filling the sheath (204) with a stabiliser material (203) to impregnate the braided sleeve (202) and the HTS cable, the stabiliser material (203) having a
melting point above 290K and below a thermal degradation temperature of the HTS tapes (201) such that the HTS current lead is configured to be bent into a desired shape, when heated to a temperature that melts the stabiliser material (203), and
retains said desired shape when cooled; and
sealing the sheath (204).

11. A method according to claim 10, wherein the sheath is a leak-tight sheath and the step of filling the sheath (204) with stabiliser material (203) comprises:
inserting pellets of the stabiliser material (203) into the leak-tight sheath (204); and
melting the pellets; or
filling the leak-tight sheath (204) with a molten wax material.

12. A method according to claim 10 or 11, and comprising, at least at one end, affixing the cable to a terminal block (300), optionally further comprising affixing the braided sleeve (202) to the terminal block (300), preferably by:
dipping the terminal block (300), a portion of the cable, and a portion of the braided sleeve (202) together into a bath of solder.

13. A method according to claim 12, and comprising bending the HTS cable prior to affixing a second terminal block (300) to the HTS cable, such that the first and second terminal block (300) are at an angle relative to each other once affixed.

14. A method according to any of claims 10 to 13, wherein the sheath is a leak-tight sheath and the leak-tight sheath (204) is formed from a heat shrink material, and comprising heating the leak-tight sheath (204) following the step of filling the leak-tight sheath (204) with the stabiliser material (203) in order to melt the stabiliser material (203) and shrink the leak-tight sheath (204).

15. A method of reshaping an HTS current lead (200), the HTS current lead (200) comprising:
an HTS cable comprising a plurality of HTS tapes (201);
a braided sleeve (202) around the HTS cable;
a stabiliser material (203) being impregnated in the HTS cable and the braided sleeve (202),
the stabiliser material (203) having a melting point above a critical temperature of the
HTS tape (201) and below a thermal degradation temperature of the HTS tapes (201); and
a sheath (204) encapsulating the stabiliser material (203); the method comprising:
heating the HTS current lead (200) to a temperature above the melting point of the stabiliser material (203) and below the degradation temperature of the HTS tapes (201);
bending the HTS current lead (200) into a desired shape; and
allowing the HTS current lead (200) to cool while maintaining it in the desired shape.

## Patentansprüche

1. Hochtemperatursupraleitende, HTS-, Stromzuführung (200) umfassend:
ein HTS-Kabel, das eine Vielzahl von HTS-Bändern (201) umfasst;
eine geflochtene Manschette (202) um das HTS-Kabel;
ein Stabilisatormaterial (203), welches das HTS-Kabel und die geflochtene Manschette (202) imprägniert,
wobei das Stabilisatormaterial (203) einen Schmelzpunkt oberhalb von 290 K und unterhalb einer thermischen Zersetzungstemperatur der HTS-Bänder (201) aufweist, sodass die HTS-Stromzuführung so konfiguriert ist, dass sie beim Erhitzen auf eine Temperatur, bei der das Stabilisatormaterial (203) schmilzt, gebogen und in eine gewünschte Form umgeformt werden kann und diese gewünschte Form beim Abkühlen beibehält.

2. HTS-Stromzuführung (200) nach Anspruch 1, wobei das Stabilisatormaterial ein Wachs (203) ist.

3. HTS-Stromzuführung (200) nach einem vorstehenden Anspruch, wobei die geflochtene Manschette (202) ein Metall umfasst und mit dem HTS-Kabel elektrisch verbunden ist, wobei das Metall gegebenenfalls Kupfer oder Messing ist.

4. HTS-Stromzuführung (200) nach einem vorstehenden Anspruch und umfassend jeweils einen Anschlussblock (300) an jedem Ende des HTS-Kabels, wobei jeder Anschlussblock (300) mit dem HTS-Band elektrisch verbunden ist und für elektrische Verbindung mit externen Komponenten konfiguriert ist.

5. HTS-Stromzuführung (200) nach Anspruch 4, wobei jeder Anschlussblock (300) mit dem HTS-Kabel verlötet ist.

6. HTS-Stromzuführung (200) nach Anspruch 4 oder 5, wobei jeder Anschlussblock (300) an der geflochtenen Manschette (202) befestigt ist oder an diese angelötet ist.

7. HTS-Stromzuführung (200) nach Anspruch 6, wobei jeder Anschlussblock (300) einen Vorsprung (303) umfasst, der sich um einen Abschnitt des HTS-Kabels erstreckt, und die geflochtene Manschette (202) sich um den Vorsprung (303) erstreckt.

8. HTS-Stromzuführung (200) nach einem vorstehenden Anspruch und eine leckdichte Ummantelung (204) umfassend, die das Stabilisatormaterial umgibt und gegebenenfalls aus einem Schrumpfmaterial gebildet ist, und gegebenenfalls:
wobei die leckdichte Ummantelung (204) so konfiguriert ist, dass sie abnehmbar ist, oder
wobei die leckdichte Ummantelung (204) eine aus einem leckdichten Material gebildete innere Ummantelung und eine aus einem Material, das nach dem Abkühlen auf unter 77 K seine strukturelle Integrität beibehält, gebildete äußere Ummantelung umfasst.

9. HTS-Stromzuführung (200) nach einem vorstehenden Anspruch, wobei die geflochtene Manschette so konfiguriert ist, dass ein Biegen des HTS-Kabels unter einen bestimmten Krümmungsradius vollständig verhindert wird.

10. Verfahren zur Herstellung einer HTS-Stromzuführung (200), wobei das Verfahren umfasst:
Bereitstellen eines HTS-Kabels, das eine Vielzahl von HTS-Bändern (201) umfasst;
Anbringen einer geflochtenen Manschette (202) um das Kabel;
Anbringen einer Ummantelung (204) um die geflochtene Manschette (202);
Füllen der Ummantelung (204) mit einem Stabilisatormaterial (203), um die geflochtene Manschette (202) und das HTS-Kabel zu imprägnieren, wobei das Stabilisatormaterial (203) einen Schmelzpunkt oberhalb von 290 K und unterhalb einer thermischen Zersetzungstemperatur der HTS-Bänder (201) aufweist, sodass die HTS-Stromzuführung so konfiguriert ist, dass sie beim Erhitzen auf eine Temperatur, die das Stabilisatormaterial (203) zum Schmelzen bringt, in eine gewünschte Form gebogen wird und diese Form beim Abkühlen beibehält; und
Versiegeln der Ummantelung (204).

11. Verfahren nach Anspruch 10, wobei die Ummantelung eine leckdichte Ummantelung ist und der Schritt zum Füllen der Ummantelung (204) mit einem Stabilisatormaterial (203) umfasst:
Einbringen von Pellets des Stabilisatormaterials (203) in die leckdichte Ummantelung (204); und
Schmelzen der Pellets; oder
Füllen der leckdichten Ummantelung (204) mit einem geschmolzenen Wachsmaterial.

12. Verfahren nach Anspruch 10 oder 11 und umfassend mindestens an einem Ende Befestigen des Kabels an einem Anschlussblock (300), gegebenenfalls ferner umfassend Befestigen der geflochtenen Manschette (202) an dem Anschlussblock (300), vorzugsweise durch:
Eintauchen des Anschlussblocks (300), eines Abschnitts des Kabels und eines Abschnitts der geflochtenen Manschette (202) in ein Lotbad.

13. Verfahren nach Anspruch 12 und umfassend Biegen des HTS-Kabels vor Befestigen eines zweiten Anschlussblocks (300) an dem HTS-Kabel, so dass der erste und der zweite Anschlussblock (300) nach dem Befestigen in einem Winkel zueinander stehen.

14. Verfahren nach einem der Ansprüche 10 bis 13, wobei die Ummantelung eine leckdichte Ummantelung ist und die leckdichte Ummantelung (204) aus einem Schrumpfmaterial ausgebildet wird, und das umfasst: Erwärmen der leckdichten Ummantelung (204) nach dem Schritt des Füllens der leckdichten Ummantelung (204) mit dem Stabilisatormaterial (203), um das Stabilisatormaterial (203) zu schmelzen und die leckdichte Ummantelung (204) zu schrumpfen.

15. Verfahren zum Umformen einer HTS-Stromzuführung (200), wobei die HTS-Stromzuführung (200) umfasst:
ein HTS-Kabel, das eine Vielzahl von HTS-Bändern (201) umfasst;
eine geflochtene Manschette (202) um das HTS-Kabel;
ein Stabilisatormaterial (203), welches das HTS-Kabel und die geflochtene Manschette (202) imprägniert,
wobei das Stabilisatormaterial (203) einen Schmelzpunkt oberhalb einer kritischen Temperatur des HTS-Bandes (201) und unterhalb einer thermischen Zersetzungstemperatur der HTS-Bänder (201) aufweist; und
eine Ummantelung (204), die das Stabilisatormaterial (203) einkapselt;
wobei das Verfahren umfasst:
Erwärmen der HTS-Stromzuführung (200) auf eine Temperatur oberhalb des Schmelzpunktes des Stabilisatormaterials (203) und unterhalb der Zersetzungstemperatur der HTS-Bänder (201);
Biegen der HTS-Stromzuführung (200) in eine erwünschte Form; und
Ermöglichen, dass die HTS-Stromzuführung (200) sich abkühlt, während sie in der erwünschten Form gehalten wird.

## Revendications

1. Conducteur de courant supraconducteur à haute température, HTS (200) comprenant :
un câble HTS comprenant une pluralité de bandes HTS (201) ;
un manchon tressé (202) autour du câble HTS ;
un matériau stabilisant (203) imprégnant le câble HTS et le manchon tressé (202),
dans lequel le matériau stabilisant (203) présente un point de fusion supérieur à 290 K et inférieur à une température de dégradation thermique des bandes HTS (201) de sorte que le conducteur de courant HTS est configuré pour être plié et remodelé dans une forme souhaitée, lorsqu'il est chauffé à une température qui fait fondre le matériau stabilisant (203), et pour conserver ladite forme souhaitée lorsqu'il est refroidi.

2. Conducteur de courant HTS (200) selon la revendication 1, dans lequel le matériau stabilisant est une cire (203).

3. Conducteur de courant HTS (200) selon une quelconque revendication précédente, dans lequel le manchon tressé (202) comprend un métal et est connecté électriquement au câble HTS, facultativement, dans lequel le métal est du cuivre ou du laiton.

4. Conducteur de courant HTS (200) selon une quelconque revendication précédente, et comprenant un bornier respectif (300) à chaque extrémité du câble HTS, chaque bornier (300) étant électriquement connecté à la bande HTS et étant configuré pour une connexion électrique à des composants externes.

5. Conducteur de courant HTS (200) selon la revendication 4, dans lequel chaque bornier (300) est soudé au câble HTS.

6. Conducteur de courant HTS (200) selon la revendication 4 ou 5, dans lequel chaque bornier (300) est fixé ou soudé au manchon tressé (202).

7. Conducteur de courant HTS (200) selon la revendication 6, dans lequel chaque bornier (300) comprend une protubérance (303) s'étendant autour d'une partie du câble HTS, et le manchon tressé (202) s'étend autour de la protubérance (303).

8. Conducteur de courant HTS (200) selon une quelconque revendication précédente, et comprenant une gaine étanche (204) entourant le matériau stabilisant, facultativement formée d'un matériau thermorétractable, et facultativement :
dans lequel la gaine étanche (204) est configurée pour être retirée, ou,
dans lequel la gaine étanche (204) comprend une gaine intérieure formée d'un matériau étanche et une gaine extérieure formée d'un matériau configuré pour maintenir l'intégrité structurelle après refroidissement à une température inférieure à 77 K.

9. Conducteur de courant HTS (200) selon une quelconque revendication précédente, dans lequel le manchon tressé est configuré pour empêcher entièrement la flexion du câble HTS en dessous d'un certain rayon de courbure.

10. Procédé de fabrication d'un conducteur de courant HTS (200), le procédé comprenant :
la fourniture d'un câble HTS comprenant une pluralité de bandes HTS (201) ;
le placement d'un manchon tressé (202) autour du câble ;
le placement d'une gaine (204) autour du manchon tressé (202) ;
le remplissage de la gaine (204) avec un matériau stabilisant (203) pour imprégner le manchon tressé (202) et le câble HTS, le matériau stabilisant (203) présentant un point de fusion supérieur à 290 K et inférieur à la température de dégradation thermique des bandes HTS (201) de sorte que le conducteur de courant HTS soit configuré pour être plié dans une forme souhaitée, lorsqu'il est chauffé à une température qui fait fondre le matériau stabilisant (203), et conserve ladite forme souhaitée lorsqu'il est refroidi ; et
le scellage de la gaine (204).

11. Procédé selon la revendication 10, dans lequel la gaine est une gaine étanche et l'étape de remplissage de la gaine (204) avec un matériau stabilisant (203) comprend :
l'insertion de pastilles de matériau stabilisant (203) dans la gaine étanche (204) ; et
la fonte des pastilles ; ou
le remplissag de la gaine étanche (204) avec un matériau de cire fondue.

12. Procédé selon la revendication 10 ou 11, comprenant, au moins à une extrémité, la fixation du câble à un bornier (300), facultativement comprenant en outre la fixation du manchon tressé (202) au bornier (300), de préférence par :
le trempage du bornier (300), d'une partie du câble et d'une partie du manchon tressé (202) ensemble dans un bain de soudure.

13. Procédé selon la revendication 12, comprenant le pliage du câble HTS avant la fixation d'un second bornier (300) au câble HTS, de sorte que le premier et le second bornier (300) soient à un angle l'un par rapport à l'autre une fois fixés.

14. Procédé selon l'une quelconque des revendications 10 à 13, dans lequel la gaine est une gaine étanche et la gaine étanche (204) est formée à partir d'un matériau thermorétractable, et comprenant le chauffage de la gaine étanche (204) après l'étape de remplissage de la gaine étanche (204) avec le matériau stabilisant (203) afin de faire fondre le matériau stabilisant (203) et de rétracter la gaine étanche (204).

15. Procédé de remodelage d'un conducteur de courant HTS (200), le conducteur de courant HTS (200) comprenant :
un câble HTS comprenant une pluralité de bandes HTS (201) ;
un manchon tressé (202) autour du câble HTS ;
un matériau stabilisant (203) imprégnant le câble HTS et le manchon tressé (202),
le matériau stabilisant (203) présentant un point de fusion supérieur à une température critique de la bande HTS (201) et inférieur à une température de dégradation thermique des bandes HTS (201) ; et
une gaine (204) encapsulant le matériau stabilisant (203) ;
le procédé comprenant :
le chauffage du conducteur de courant HTS (200) à une température supérieure au point de fusion du matériau stabilisant (203) et inférieure à la température de dégradation des bandes HTS (201) ;
le pliage du conducteur de courant HTS (200) selon une forme souhaitée ; et
la permission au conducteur de courant HTS (200) de refroidir tout en le maintenant dans la forme souhaitée.
